# EUROPÄISCHE PATENTSCHRIFT

(11) **EP 3 645 975 B1**
(45) Veröffentlichungstag und Bekanntmachung des Hinweises auf die Patenterteilung: **30.03.2022**
(21) Anmeldenummer: 18738192.6
(22) Anmeldetag: 20.06.2018
(51) Int. Cl.: G01D 4/00, G01R 22/06, H04L 12/66, H04Q 9/00

(54) **KOMMUNIKATIONSMODUL ZUR ERFASSUNG VON VERBRAUCHSDATEN EINES ZÄHLERS**
COMMUNICATION MODULE FOR COLLECTING CONSUMPTION DATA OF A COUNTER
MODULE DE COMMUNICATION POUR COLLECTER DES DONNÉES DE CONSOMMATION D'UN COMPTEUR

(30) Priorität: 29.06.2017 DE 102017006506
(43) Veröffentlichungstag der Anmeldung: 06.05.2020
(73) Patentinhaber: Diehl Metering Systems GmbH, 90451 Nürnberg (DE)
(72) Erfinder: WESTPHAL, Robert, 88239 Wangen (DE); VORBURGER, Philippe, 63390 Sausheim (FR); FEUCHTMEIER, Jörg, 90522 Oberasbach (DE); GOTTSCHALK, Roland, 91126 Schwabach (DE); GOTTSCHALK, Klaus, 90610 Winkelhaid (DE)
(74) Vertreter: Diehl Patentabteilung
(86) Internationale Anmeldenummer: PCT/EP2018/000311
(87) Internationale Veröffentlichungsnummer: WO 2019/001762

(56) Entgegenhaltungen:
- WO-A1-2015/184161
- DE-A1- 10 126 816
- DE-U1-202007 017 510
- US-A1- 2002 082 748
- US-A1- 2003 009 301
- US-A1- 2008 106 434
- US-A1- 2009 073 070

## Beschreibung

Die vorliegende Erfindung betrifft Kommunikationsmodul zur Erfassung von Verbrauchsdaten eines Zählers, insbesondere eines Strom-, Gas-, Wasser- oder Wärmemengenzählers gemäß dem Oberbegriff des Anspruchs 1.

### Technologischer Hintergrund

Intelligente Verbrauchszähler, auch Smart Meter genannt, sind in einem Versorgungsnetz befindliche Verbrauchsmessgeräte, z. B. für Energie, Strom, Gas oder Wasser, die dem jeweiligen Anschlussbenutzer den tatsächlichen Verbrauch anzeigen und in ein Kommunikationsnetz eingebunden sind. Intelligente Verbrauchszähler haben den Vorteil, dass manuelle Ablesungen der Zählerstände entfallen und seitens des Versorgers kurzfristigere Rechnungstellungen gemäß dem tatsächlichen Verbrauch vorgenommen werden können. Durch kurzfristigere Ableseintervalle ist wiederum eine genauere Kopplung der Endkundentarife an die Entwicklung der Börsenstrompreise möglich. Auch können Versorgungsnetze wesentlich besser ausgelastet werden.

Intelligente Verbrauchszähler sind üblicherweise jeweils Wohneinheiten oder Wohnhäusern zugeordnet. Die dort anfallenden Messdaten bzw. Informationen können auf unterschiedlichste Weise ausgelesen werden. Sie können z. B. über das Stromnetz (Power Line) oder via Funktechnologie (z. B. Mobilfunk, im ISM (Industrial, Scientific, Medical)-Band-Frequenzbereich oder dergleichen) in Form von Datenpaketen oder Telegrammen ausgelesen werden. Ferner können die Informationen dadurch in ein überörtliches Netzwerk eingebunden werden.

Zweckmäßigerweise werden den Verbrauchszählern zur Funkübertragung der Informationen Kommunikationsmodule zugeordnet, die in den Verbrauchszählern integriert bzw. installiert sind. Derartige Kommunikationsmodule besitzen in der Regel eine fest vorinstallierte Sende- und Empfangseinheit sowie eine Antenne zum Senden und Empfangen der Informationen. Die Sende- und Empfangseinheit wird werksseitig derart vorkonfektioniert, dass diese über die bevorzugte Funktechnologie bzw. das bevorzugte Übertragungsprotokoll verfügt, d. h. darüber senden und empfangen kann.

Ferner nutzen unterschiedliche Verbrauchszähler bzw. die Hersteller der Verbrauchszähler unterschiedliche Übertragungsprotokolle zur Informationsübertragung. Zudem entwickeln sich diese Übertragungsprotokolle weiter oder es kommen neue verbesserte Übertragungsprotokolle auf den Markt, sodass die Kommunikationsmodule der Verbrauchszähler vermehrt aktualisiert werden müssen.

### Nächstliegender Stand der Technik

In der WO 2015/184161 werden Geräte offenbart, die mit einer Beleuchtungsanwendung verbunden sind, und mehrere Kommunikationstechnologien für die Kommunikation mit mehreren Geräten nutzen können, die unterschiedliche Einschränkungen beim Stromverbrauch und unterschiedliche Übertragungsbereiche haben. Kommunikation und Signalgebung können so verwaltet werden, dass die Batterielebensdauer verlängert wird. Ein Kommunikationsknoten in der Anwendung kann die Kommunikation innerhalb und zwischen Netzwerken unterstützen, beispielsweise mit entfernten Geräten und Systemen.

Die US 2008/0106434 beschreibt ein System und Verfahren zum Sammeln von Verbrauchsdaten von einer Vielzahl von Standorten, durch eine Zählereinheit und eine Verstärkereinheit für jeden Standort in einer Zentralstation. Die Zählereinheit enthält eine Messvorrichtung zum Messen des Stromverbrauchs an dem jeweiligen Standort und einen Kurzstrecken-Sender/Empfänger. Die Verstärkereinheit enthält einen Kurzstrecken-Transceiver für die Kommunikation mit dem Kurzstrecken-Transceiver der Zählereinheit am jeweiligen Standort über einen Kurzstrecken-Übertragungskanal; und einen Langstrecken-Transmitter für die Übertragung von Verbrauchsdaten über einen Langstrecken-Übertragungskanal an die Zentralstation.

In der US 2009/0073070 wird eine Dual-Band-Antenne offenbart, die eine Fernfeld-Antennenstruktur zur Erleichterung der Kommunikation erster Daten mit einem entfernten Gerät über Fernfeld-Signalisierung in einem Millimeterwellenband umfasst. Eine Nahfeld-Antennenstruktur erleichtert die Kommunikation von zweiten Daten mit einem entfernten Gerät über Nahfeldsignalisierung in einem Nahfeldband. Die Fernfeld-Antennenstruktur und die Nahfeld-Antennenstruktur teilen sich mindestens ein gemeinsames Antennenelement.

Die DE 101 26 816 A1 beschreibt ein System zur Fernkommunikation mit Haushaltsgeräten, wobei die Geräteschnittstelle über ein vorzugsweise umschaltbares oder umprogrammierbares Anpassungsnetzwerk an Netzmodule unterschiedlicher Protokolle schaltbar ist, insbesondere ein DECT-Funkprotokoll. Über eine häusliche DECT-Basisstation kann ein Betriebszustand am ausgewählten Haushaltsgerät abgefragt bzw. in dessen Programmablauf eingegriffen werden.

In der US 2003/0009301 wird ein System zur Überwachung, Verwaltung, Abrechnung und Bezahlung der Versorgungsnutzung offenbart. Zählerablesegeräte sind über ein geografisches Gebiet verteilt und übertragen Nutzungsdaten an ein Steuergerät, das diese Daten über ein globales Kommunikationsnetz an ein Servicegerät weiterleitet.

Die US 2002/0082748 beschreibt eine Kommunikationsmethode zur Steuerung der Versorgungsnachfrage in entfernten Systemen, zur Erfassung von Versorgungsdaten in automatisierten Systemen und zur Steuerung der Versorgungsnachfrage und von Datensystemen in kombinierten Systemen. Ferner wird ein System zur Fernsteuerung der Versorgungsnachfrage und/oder ein automatisiertes Datenerfassungssystem beschrieben. Es werden verschiedene Methoden der Kommunikation einerseits zwischen einer Einheit zur Steuerung der Versorgungsnachfrage und Verbrauchsverfolgung, die mit verschiedenen Verbrauchsgeräten verbunden ist, und andererseits einer zentralisierten Einheit zur Befehlsübertragung und Datenerfassung beschrieben.

Aus der DE 10 2005 051 159 B4 ist ein Kommunikationsmodul zum Einsetzen in einen Zähler bekannt, wobei der Zähler eine Messeinrichtung umfasst, die dazu dient, einen zählertypspezifischen Informationswert über ein in einer Leitung strömendes flüssiges oder gasförmiges Medium zu ermitteln. Das Kommunikationsmodul umfasst ein standardisiertes, in seiner Form entsprechend einer standardisierten Ausnehmungsform des Zählers, angepasstes Gehäuse. Das Kommunikationsmodul kommuniziert im Betrieb mit der Messeinrichtung, wobei eine standardisierte, zählertypspezifisch konfigurierbare Steuerungseinrichtung mit zugeordneten Übertragungsmitteln zum Übertragen der zählertypspezifischen Informationswerte an eine externe Erfassungseinrichtung vorgesehen ist. Die Messeinrichtung und das Kommunikationsmodul kommunizieren hierbei über eine standardisierte, leitungslose Kommunikationsschnittstelle, bei der es sich bevorzugt um eine kapazitive Schnittstelle handelt. Der Nachteil dieses Kommunikationsmoduls ist, dass nur Zähler angeschlossen werden können, die eine bestimmte kapazitive Schnittstelle sowie ein entsprechend ausgestaltetes Gehäuse aufweisen, sodass für den jeweiligen Zähler ein individuelles Kommunikationsmodul erforderlich ist. Dementsprechend unflexibel ist das Einsatzgebiet des Kommunikationsmoduls.

### Aufgabe der vorliegenden Erfindung

Die Aufgabe der vorliegenden Erfindung besteht darin, ein kostengünstiges Kommunikationsmodul zur Verfügung zu stellen, welches flexibel und in einfacher Weise an einen Zähler angeschlossen werden kann und mit welchem die Übertragungsqualität und Übertragungsreichweite verbessert werden.

### Lösung der Aufgabe

Die vorstehende Aufgabe wird durch die gesamte Lehre des Anspruchs 1 gelöst. Zweckmäßige Ausgestaltungen der Erfindung sind in den Unteransprüchen beansprucht.

Erfindungsgemäß handelt es sich bei der ersten Kommunikationsschnittstelle des Kommunikationsmoduls um eine insbesondere standardisierte Nahbereichsschnittstelle zur drahtlosen Anbindung des Zählers, welche eine Mehrzahl von insbesondere standardisierten Übertragungsprotokollen wahlweise unterstützt.

Demgegenüber handelt es sich bei der zweiten Kommunikationsschnittstelle um eine insbesondere standardisierte Fernbereichsschnittstelle, welche entsprechend auch eine Mehrzahl von insbesondere standardisierten Übertragungsprotokollen insbesondere zur Datenfernübertragung wahlweise unterstützt. Dadurch hat das Kommunikationsmodul bzw. der Benutzer die Möglichkeit, zwischen Übertragungsprotokollen zur Datenübertragung zu wählen. Beispielsweise können verschiedene Zähler, die unterschiedliche Übertragungsprotokolle unterstützen, in einfacher Weise an ein und dasselbe Kommunikationsmodul angeschlossen werden, indem das jeweilig zum Anschluss benötigte Übertragungsprotokoll durch den Benutzer oder selbsttätig durch das Kommunikationsmodul gewählt wird. Ferner kann bei der Fernbereichskommunikation zwischen verschiedenen

Übertragungsprotokollen gewählt werden, um mit Datensammlern, Schaltzentralen oder dergleichen über verschiedene Übertragungsprotokolle zu kommunizieren. Somit wird durch das erfindungsgemäße Kommunikationsmodul eine flexible und kostengünstige Anschlussmöglichkeit bereitgestellt, durch die eine Kommunikation zwischen über unterschiedliche Übertragungsprotokolle kommunizierende Einheiten, wie z. B. Zähler, Datensammler, Kommunikationsmodule unterschiedlicher Hersteller oder dergleichen, ermöglicht wird, d. h. das Kommunikationsmodul besitzt auch eine Art Übersetzerfunktion. Hierdurch kann z. B. die Datenübertragung verschiedener Zähler an einen Datenkonzentrator in einfacher Weise vereinheitlicht werden. Ferner können die Übertragungsprotokolle in Hinblick auf die benötigte Übertragungsqualität und Übertragungsreichweite der Datenübertragung an die jeweilige Übertragungssituation angepasst werden, so dass Übertragungsqualität sowie Übertragungsreichweite in besonderem Maße verbessert werden.

Erfindungsgemäß ist entweder eine einzige Antenne zur Kommunikation über die erste und die zweite Kommunikationsschnittstelle vorgesehen oder es sind eine erste Antenne zur Kommunikation über die erste Kommunikationsschnittstelle und eine zweite Antenne zur Kommunikation über die zweite Kommunikationsschnittstelle vorgesehen.

Zweckmäßigerweise kann die erste Kommunikationsschnittstelle mindestens zwei Übertragungsprotokolle aus folgender Gruppe umfassen: Near Field Communication (NFC), Infrarot (Infrared Data Association, IrDA), Bluetooth, Bluetooth Low Energy (BLE), Open Metering System (OMS) und induktive Übertragung. Dadurch kann eine sichere und energiesparende Nahbereichskommunikation sichergestellt werden.

Ferner kann eine dritte Kommunikationsschnittstelle vorgesehen sein, über die die Verbrauchsdaten vom Zähler zum Kommunikationsmodul übertragbar sind. Über die dritte Kommunikationsschnittstelle können beispielsweise alternative Übertragungsmöglichkeiten bzw. Übertragungsprotokolle adaptiert werden. Vorzugsweise handelt es sich bei der dritten Kommunikationsschnittstelle um eine insbesondere nicht-standardisierte Nahbereichs- und/oder insbesondere nicht-standardisierte Fernbereichsschnittstelle, welche mindestens ein oder wahlweise mehrere insbesondere nicht-standardisierte Übertragungsprotokolle unterstützt. Beispielsweise kann dadurch ein herstellereigenes Übertragungsprotokoll implementiert werden, um das Kommunikationsmodul z. B. in ein eigenes Kommunikationsnetz mit eigenen Sicherheits- und Übertragungsstandards zu integrieren. Die Übertragungsqualität und Datensicherheit kann dadurch in besonderem Maße verbessert werden.

Zweckmäßigerweise kann es sich bei der oder den Antenne(n) um (eine) innerhalb des Kommunikationsmoduls integrierte Antenne(n) handeln. Dadurch kann das Kommunikationsmodul besonders platzsparend ausgestaltet werden, indem die Antenne(n) individuell an den Bauraum angepasst wird/werden.

Ferner können auch mehrere Antennen für die jeweiligen Übertragungsmöglichkeiten, z. B. zur Nah- und zur Fernbereichsübertragung, vorgesehen sein. Beispielsweise kann es sich bei der Antenne zur Fernbereichsübertragung um eine PIF-Antenne (planar inverted F-shaped antenna) handeln, welche z. B. direkt auf einer Steuerplatine des Kommunikationsmoduls integriert sein kann. Der Resonanzpunkt kann hierbei derart ausgelegt werden, dass die jeweilige Antenne nur für ein Frequenzband oder auch für mehrere Frequenzbänder verwendet wird, um z. B. über die typischen Resonanzfrequenzen bei 800-900 MHz (z. B. ISM-Bänder im Bereich von 868-873 MHz) und zusätzlich auch über 2,4 GHz (WLAN) senden zu können. Ferner kann zur Nahbereichsübertragung (z. B. über 13,56 MHz) auch eine magnetisch-induktive Antenne vorgesehen sein, wie z. B. ein RFID-Transponder.

Das Kommunikationsmodul umfasst erfindungsgemäß Mittel zum Festlegen des jeweiligen Übertragungsprotokolls. Beispielsweise kann das Kommunikationsmodul als Mittel eine Detektionsfunktion umfassen, die dazu hergerichtet ist, sämtliche unterstützte Übertragungsprotokolle, Funkstandards, Funksysteme oder dergleichen schrittweise abzufragen und nach einem Antwortsignal zu suchen, um den Übertragungsstandard bzw. das Übertragungsprotokoll zu identifizieren über den das anzuschließende Gerät bzw. der Zähler kommunizieren kann. Anschließend wird dieser Übertragungsstandard zur Anbindung des Zählers selbsttätig gewählt.

Zusätzlich ist eine Störerdetektion vorgesehen, anhand der die Festlegung der Übertragungsart erfolgt, sodass z. B. die Frequenzkanäle und/oder Übertragungsprotokolle mit den bestmöglichen Übertragungseigenschaften gewählt werden. Die Übertragungsqualität und Übertragungssicherheit wird dadurch in besonderem Maße verbessert.

Zweckmäßigerweise kann ein Datenspeicher zum Speichern der Verbrauchsdaten vorgesehen sein. Dadurch können die Verbrauchsdaten auch über längere Zeiträume gespeichert werden, sodass z. B. auch bei andauernden Störbelastungen eine Übertragung der Verbrauchsdaten zu einem späteren Zeitpunkt stattfinden kann. Dadurch können Datenverluste aufgrund von mangelhaften Speicherkapazitäten vermieden werden.

Ferner ist das Kommunikationsmodul erfindungsgemäß dazu hergerichtet, mit einer Mehrzahl von Zählern und/oder übergeordneten Datensammeleinrichtungen und/oder Kommunikationsmodulen zu kommunizieren. Beispielsweise kann auch über ein Kommunikationsmodul eine Mehrzahl von unterschiedlichen Zählern angeschlossen werden, z. B. Gas-, Wasser-, Wärmemengen- und Stromzähler. Dadurch können diese Zählertypen über das Kommunikationsmodul an eine Smart-Home-Steuerung angeschlossen werden. Für diesen Anschluss benötigt die Smart-Home-Steuerung eine Kommunikationseinrichtung, die z. B. auch nur über eines der im Kommunikationsmodul implementierten Übertragungsprotokolle kommunizieren kann. Somit können auch Zähler, die nur Funktechnologien unterstützen, welche wiederum die Smart-Home-Steuerung nicht unterstützt, in einfacher Weise an die Smart-Home-Steuerung über das Kommunikationsmodul angeschlossen werden. Die Nachrüstbarkeit von neuartigen Zählern sowie die Implementierung neuartiger Übertragungsstandards in bestehenden Technologien, wie z. B. Smart-Home-Steuerungen, werden dadurch erheblich vereinfacht. Ferner kann das Kommunikationsmodul auch mit anderen Teilnehmern der Smart-Home-Steuerung kommunizieren, um diese einzubinden.

Gemäß einer besonderen Ausgestaltung kann auch das Kommunikationsmodul dazu hergerichtet sein, den Zähler über eine der Kommunikationsschnittstellen mit Energie zu versorgen. Beispielsweise kann dies über ein drahtloses NFC-Ladesystem erfolgen, d. h. insbesondere über die Kommunikationsmittel (z. B. Antenne) der ersten Kommunikationsschnittstelle.

### Beschreibung der Erfindung anhand von Ausführungsbeispielen

Zweckmäßige Ausgestaltungen der vorliegenden Erfindung werden anhand von Zeichnungsfiguren nachstehend näher erläutert. Es zeigen:
- Fig. 1a: eine stark vereinfachte, schematische Darstellung einer Ausgestaltung eines erfindungsgemäßen Kommunikationsmoduls;
- Fig. 1b: eine stark vereinfachte, schematische Darstellung einer weiteren Ausgestaltung des erfindungsgemäßen Kommunikationsmoduls;
- Fig. 1c: eine stark vereinfachte, schematische Darstellung einer weiteren Ausgestaltung des erfindungsgemäßen Kommunikationsmoduls;
- Fig. 2: eine stark vereinfachte, schematische Darstellung eines mehrere Kommunikationsmodule umfassenden Kommunikationssystems;
- Fig. 3a: eine stark vereinfachte, schematische Darstellung der ersten Kommunikationsschnittstelle des erfindungsgemäßen Kommunikationsmoduls;
- Fig. 3b: eine stark vereinfachte, schematische Darstellung der zweiten Kommunikationsschnittstelle des erfindungsgemäßen Kommunikationsmoduls;
- Fig. 4a: eine stark vereinfachte, schematische Darstellungen der ersten Kommunikationsschnittstelle des erfindungsgemäßen Kommunikationsmoduls mit angebundener Kommunikationsschnittstelle eines Zählers, sowie
- Fig. 4b: eine stark vereinfachte, schematische Darstellungen der ersten Kommunikationsschnittstelle des erfindungsgemäßen Kommunikationsmoduls mit angebundener Kommunikationsschnittstelle eines Zählers.

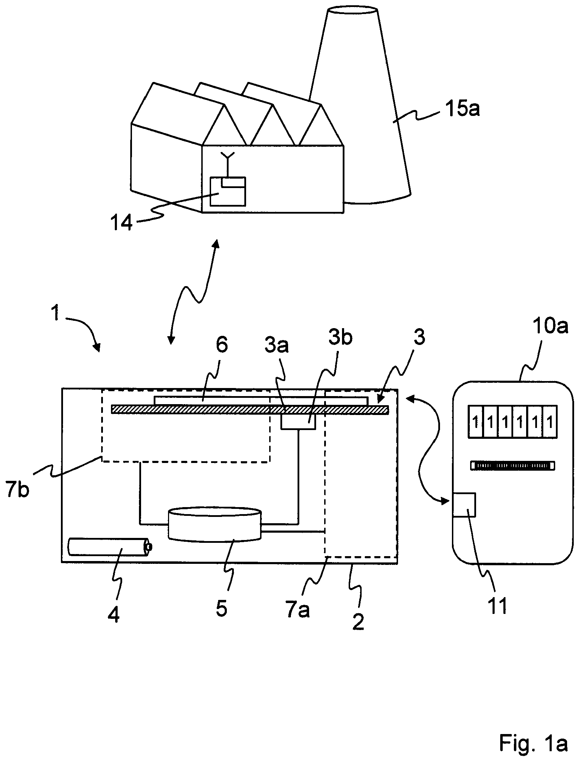

Bezugsziffer 1 in Fig. 1a bezeichnet eine Ausgestaltungsvariante des erfindungsgemäßen Kommunikationsmoduls. Das Kommunikationsmodul 1 umfasst ein Gehäuse 2, eine Steuereinrichtung 3 sowie eine eigene Energiequelle 4, wie z. B. einen Akkumulator oder eine Batterie. Die Steuereinrichtung 3 ist als Steuerplatine 3a ausgestaltet, die einen Mikroprozessor 3b umfasst, welcher im Wesentlichen zur Steuerung des Kommunikationsmoduls 1 dient. Zudem umfasst das Kommunikationsmodul 1 einen Datenspeicher 5 zur Datenspeicherung, auf den die Steuereinrichtung 3 zugreifen kann. Das Kommunikationsmodul besitzt eine Antenne 6, die als eine auf der Steuerplatine 3a angeordnete PCB-Antenne (printed circuit board antenna) ausgestaltet ist und zur Nah- sowie Fernbereichskommunikation geeignet ist.

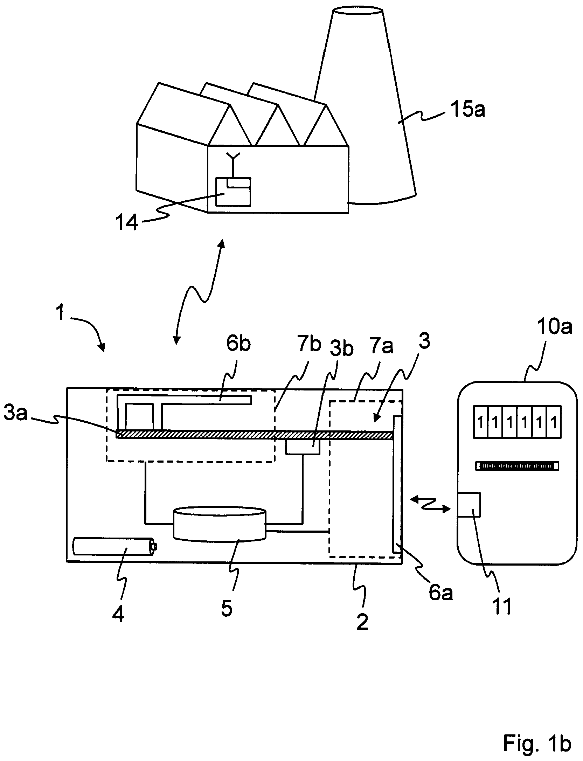

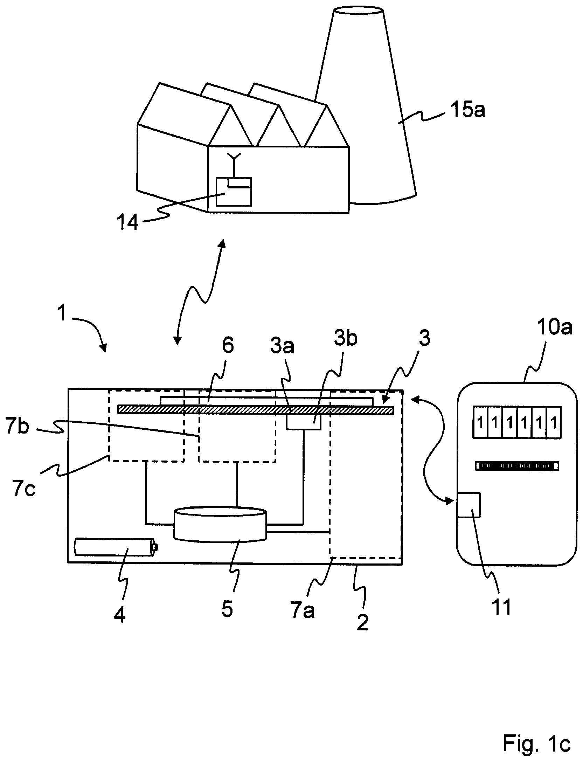

Ferner umfasst das Kommunikationsmodul 1 eine Kommunikationsschnittstelle 7a, die als standardisierte Nahbereichsschnittstelle ausgestaltet ist, und eine Kommunikationsschnittstelle 7b, die als standardisierte Fernbereichsschnittstelle ausgestaltet ist. Die Kommunikationsschnittstelle 7a ist dazu hergerichtet, eine drahtlose Anbindung eines Zählers 10a zu ermöglichen, um z. B. die Verbrauchsdaten des Zählers 10a zu erfassen. Hierzu umfasst auch der Zähler 10a eine Kommunikationsschnittstelle 11 zur Verbrauchsdatenübertragung. Die Verbrauchsdaten werden hierbei vom Kommunikationsmodul 1 über die Kommunikationsschnittstelle 7a empfangen und z. B. im Datenspeicher 5 zwischengespeichert. Anschließend können die Verbrauchsdaten aus dem Datenspeicher 5 entnommen und über die Kommunikationsschnittstelle 7b an eine übergeordnete Datensammeleinrichtung übertragen werden. Wie in Fig. 1 gezeigt, handelt es sich bei der Datensammeleinrichtung beispielsweise um einen Datensammler 14 innerhalb einer Schaltzentrale des Versorgers 15a.

Gemäß einer besonderen Ausgestaltung nach Fig. 1b, kann das Kommunikationsmodul 1 auch mehrere Antennen 6a, 6b umfassen. Zweckmäßigerweise sind die Antennen 6a, 6b direkt an der Steuerplatine 4a der Steuereinrichtung 4 angeordnet, d. h. innerhalb des Gehäuses 2 angeordnet. Alternativ ist es denkbar, dass die Antennen 6a und/oder 6b, zumindest teilweise, in das Gehäuse 2 integriert sind, d. h. insbesondere eingeklebt oder eingegossen sind. Die Antenne 6a dient zur Nahbereichsübertragung und ist somit der ersten Kommunikationsschnittstelle 7a zugeordnet. Bei der Antenne 6a kann es sich beispielsweise um eine magnetisch-induktive Antenne 6a handeln, die als Spule ausgebildet ist, wie z. B. eine Folienantenne, deren leitende Strukturen auf eine Folie aufgedruckt sind. Die Antenne 6a ist hierbei möglichst nah am Gehäuse 2 angeordnet, um eine gute Übertragungsqualität zu gewährleisten. Darüber hinaus ist eine Antenne 6b vorgesehen, die als PIF-Antenne (planar inverted F-shaped antenna) ausgestaltet ist und zur Fernbereichsübertragung dient, d. h. der zweiten Kommunikationsschnittstelle 7b zugeordnet ist.

Das Kommunikationsmodul 1 kann auch, wie in Fig. 1c gezeigt, eine dritte Kommunikationsschnittstelle 7c sowie weitere, in den Figuren nicht dargestellte, Kommunikationsschnittstellen aufweisen. Bei der dritten Kommunikationsschnittstelle 7c handelt es sich z. B. um eine nicht-standardisierte Nahbereichs- und/oder nicht-standardisierte Fernbereichsschnittstelle, über welche die Verbrauchsdaten z. B. vom Zähler 10a zum Kommunikationsmodul 1 oder vom Kommunikationsmodul 1 zur Datensammeleinrichtung über mindestens ein oder wahlweise mehrere nicht-standardisierte Übertragungsprotokolle übertragen werden.

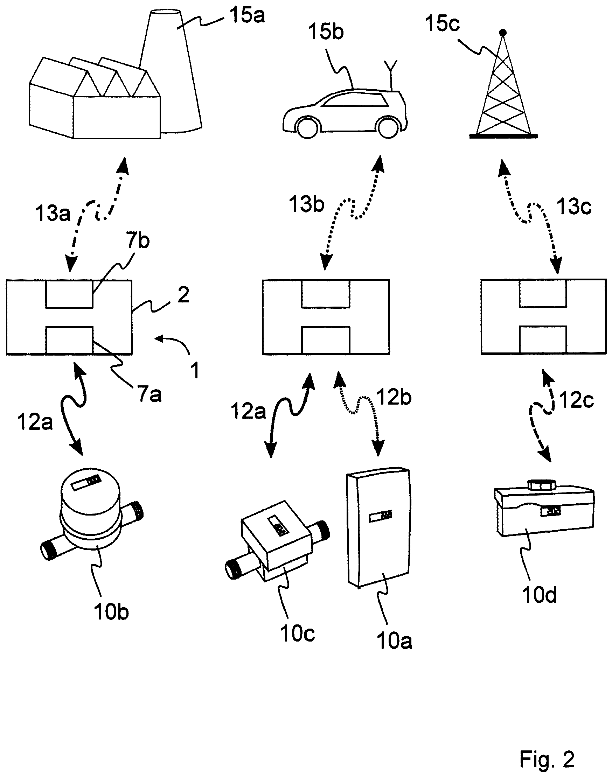

In Fig. 2 ist ein Kommunikationssystem dargestellt, das mehrere externe, autarke Kommunikationsmodule 1 umfasst, die jeweils zur Anbindung von ein oder mehreren Zählern für Strom 10a, Wasser 10b, Wärmemenge 10c oder Gas 10d an das Kommunikationssystem vorgesehen sind. Die Kommunikationsmodule 1 übertragen jeweils die Verbrauchsdaten der Zähler 10a, 10b, 10c, 10d an eine übergeordnete Datensammeleinrichtung, wie die Schaltzentrale des Versorgers 15a, einen mobilen Datensammler 15b, der z. B. bei Drive-by- oder Walk-by-Ablesungen verwendet wird, oder einen stationären Konzentrator 15c, der z. B. an einem Knotenpunkt angeordnet ist oder innerhalb eines Haushaltes zur Anbindung einer Smart-Home-Steuerung hergerichtet ist. Die Kommunikation zwischen Kommunikationsmodul 1 und den jeweiligen Zähler 10a, 10b, 10c, 10d bzw. der jeweiligen Datensammeleinrichtung erfolgt über verschiedene Übertragungsprotokolle. Die Kommunikation über unterschiedliche Übertragungsprotokolle ist in Fig. 2 anhand unterschiedlich gestrichelter Kommunikationsverbindungen 12a-12c bzw. 13a-13c dargestellt.

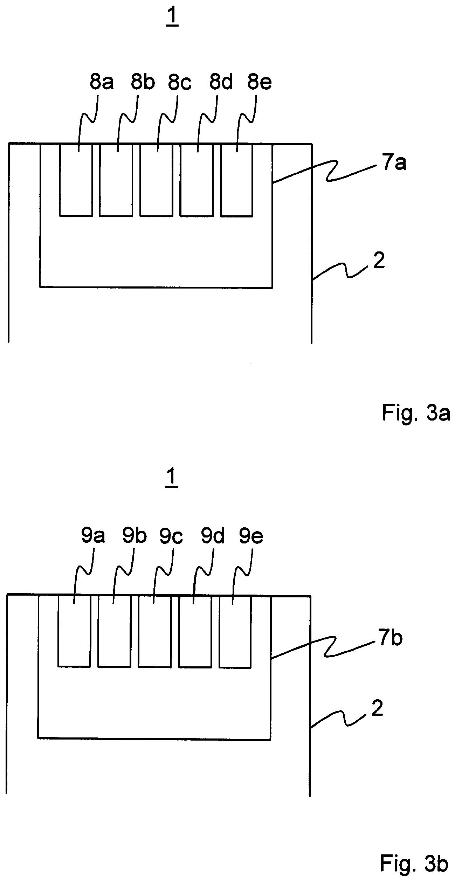

Wie in Fig. 3a dargestellt, ist die Kommunikationsschnittstelle 7a zur Kommunikation zwischen Kommunikationsmodul 1 und Zähler 10a, 10b, 10c, 10d derart ausgestaltet, dass die Kommunikation wahlweise anhand einer Mehrzahl von standardisierten Übertragungsprotokollen 8a-8e erfolgen kann, d. h. mehrere Übertragungsprotokolle 8a-8e werden nebeneinander unterstützt. Gleichermaßen unterstützt auch die zweite Kommunikationsschnittstelle 7b, wie in Fig. 3b gezeigt, eine Mehrzahl von standardisierten Übertragungsprotokollen 9a-9e, über die wahlweise übertragen werden kann.

Vorzugsweise kann die erste Kommunikationsschnittstelle 7a hierbei mindestens zwei standardisierte Übertragungsprotokolle 8a-8e insbesondere aus folgender Gruppe umfassen: Near Field Communication (NFC), Infrarot (Infrared Data Association, IrDA), Bluetooth, Bluetooth Low Energy (BLE), Open metering System (OMS) und/oder induktive Übertragung. Demgegenüber kann die zweite Kommunikationsschnittstelle 7b zur Übertragungsprotokolle 9a-9e insbesondere aus folgender Gruppe umfassen: Funkstandards zur Datenfernübertragung, Mobilfunkstandards (z. B. GSM, GPRS, 3G, 4G,...), Drahtkommunikation (z. B. MBus, RS485,...) bis hin zu Internet of Things-Applikationen (z. B. LoRa, SigFox, WLAN, NB-LTE,...).

Bei den genannten Übertragungsmöglichkeiten bzw. Übertragungsprotokollen handelt es sich insbesondere um eine nicht-abschließende Auflistung, die im Rahmen der Erfindung wahlweise durch andere aus dem Stand der Technik bekannte Übertragungsprotokolle erweiterbar ist.

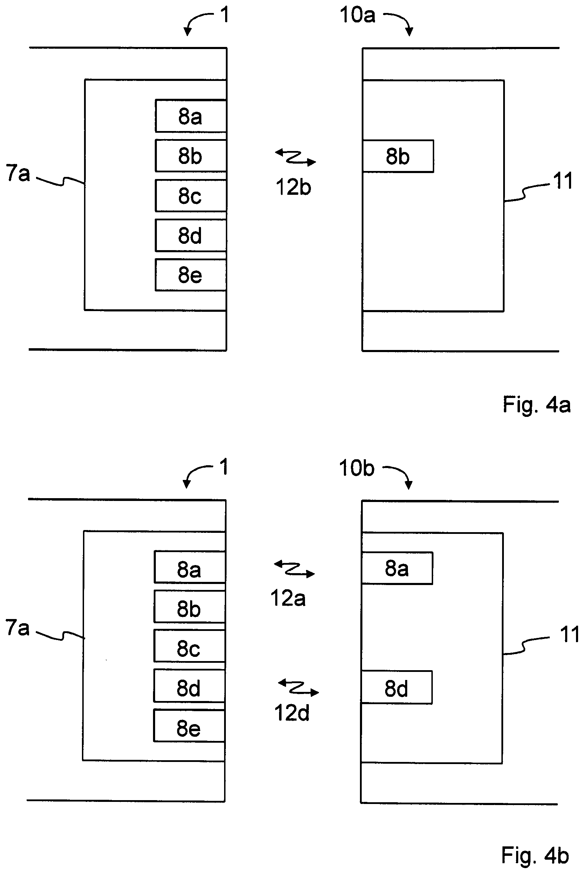

Beispielsweise kann das Kommunikationsmodul 1 gemäß Fig. 4a mit der Kommunikationsschnittstelle 11 des Stromzählers 10a kommunizieren. Die Kommunikationsschnittstelle 11 unterstützt hierbei das Übertragungsprotokoll 8b, z. B. Bluetooth LE. Das Kommunikationsmodul 1 ist dabei derart konfiguriert, dass dieses Übertragungsprotokoll 8b vorzugsweise selbsttätig vom Kommunikationsmodul 1 erkannt wird, z. B. mittels Funk- oder Kanalabtastung, und die Kommunikationsschnittstelle 7a dementsprechend einrichtet, dass die Kommunikation bzw. Datenübertragung über das Übertragungsprotokoll 8b erfolgt. Demgegenüber kann das Kommunikationsmodul 1 gemäß Fig. 4b mit der Kommunikationsschnittstelle 11 des Stromzählers 10b kommunizieren. Die Kommunikationsschnittstelle 11 unterstützt hierbei das Übertragungsprotokoll 8a sowie 8d, z. B. IrDA und NFC. Nach einer Erkennung der Übertragungsprotokolle 8a bzw. 8d kann das Kommunikationsmodul 1, das Übertragungsprotokoll 8a bzw. 8d auswählen und die Kommunikationsschnittstelle 7a dementsprechend einrichten, sodass die Kommunikation bzw. Datenübertragung wahlweise über das Übertragungsprotokoll 8a und/oder 8d erfolgt. Darüber hinaus kann das Kommunikationsmodul 1 beispielsweise eine Störerdetektion und/oder eine Übertragungsprotokollbewertung umfassen, anhand derer das für die aktuell vorliegende Übertragungssituation am besten geeignete Übertragungsprotokoll 8a-8e gewählt wird.

Zusammenfassend wird durch das erfindungsgemäße Kommunikationsmodul 1 die Kommunikationsschnittstelle 11, insbesondere eine standardisierte Nahbereichsschnittstelle, eines Smart Meters (z. B. Zähler 10a, 10b, 10c, 10d) genutzt, um das Kommunikationsmodul 1 über eine standardisierte Nahbereichsschnittstelle des Kommunikationsmoduls 1 mit dem Smart Meter drahtlos zu verbinden, um z. B. Zählerdaten bzw. Verbrauchsdaten zu übertragen. Die Zählerdaten werden hierbei, mithilfe der entsprechenden integrierten Technologie (bzw. Übertragungsprotokollen wie BLE, NFC, IrDA, induktiv, OMS,...) übertragen. Das Kommunikationsmodul 1 bzw. die erste Kommunikationsschnittstelle 7a unterstützt dabei eine Mehrzahl von Übertragungsprotokollen 8a-8e bzw. 9a-9e, die zählerspezifisch ausgewählt werden können. Demzufolge erfolgt durch den Einsatz eines erfindungsgemäßen Kommunikationsmoduls 1 eine Trennung von Metrologie und Kommunikationstechnik. Die Vorteile der Erfindung liegen hierbei insbesondere in der Flexibilität der Systemauslegung, der Nutzung standardisierter Technologien für die Datenkommunikation und durch Verlagerung der Kommunikation nach außen, d. h. in ein externes Kommunikationsmodul 1, eine Erhöhung der Lebensdauer, der Flexibilität und der Robustheit des Smart Meters im Feld. Ausdrücklich vom Offenbarungsgehalt umfasst sind auch Einzelmerkmalskombinationen (Unterkombinationen) sowie mögliche, nicht in den Zeichnungsfiguren dargestellte Kombinationen einzelner Merkmale unterschiedlicher Ausgestaltungsformen, sofern sie Gegenstand der Ansprüche sind.

### BEZUGSZEICHENLISTE

- 1: Kommunikationsmodul
- 2: Gehäuse
- 3: Steuereinrichtung
- 3a: Steuerplatine
- 3b: Mikroprozessor
- 4: Energiequelle
- 5: Datenspeicher
- 6: Antenne
- 6a: Antenne
- 6b: Antenne
- 7a: Kommunikationsschnittstelle
- 7b: Kommunikationsschnittstelle
- 7c: Kommunikationsschnittstelle
- 8a-8e: standardisiertes Übertragungsprotokoll
- 9a-9e: standardisiertes Übertragungsprotokoll
- 10a: Zähler (Strom)
- 10b: Zähler (Wasser)
- 10c: Zähler (Wärmemenge)
- 10d: Zähler (Gas)
- 11: Kommunikationsschnittstelle (Zähler)
- 12a-12e: Kommunikationsverbindung
- 13a-13c: Kommunikationsverbindung
- 14: Datensammler
- 15a: Schaltzentrale des Versorgers
- 15b: mobiler Datensammler
- 15c: stationären Konzentrator

## Patentansprüche

1. Kommunikationsmodul (1) zur Erfassung von Verbrauchsdaten eines Zählers (10a, 10b, 10c, 10d), insbesondere Verbrauchsmengen an Strom, Gas, Wasser oder Wärme, wobei das Kommunikationsmodul (1) dazu dient, Verbrauchsdaten von dem Zähler (10a, 10b, 10c, 10d) zu empfangen und die Übertragung der Verbrauchsdaten des Zählers (10a, 10b, 10c, 10d) an eine übergeordnete Datensammeleinrichtung zu ermöglichen, mit
einem Gehäuse (2)
einer Steuereinrichtung (3),
einer eigenen Energiequelle (4),
einer ersten Kommunikationsschnittstelle (7a) zur drahtlosen Anbindung des Zählers über die die Verbrauchsdaten vom Zähler (10a, 10b, 10c, 10d) zum Kommunikationsmodul (1) übertragbar sind,
einer zweiten Kommunikationsschnittstelle (7b), über die die Verbrauchsdaten vom Kommunikationsmodul (1) zu der Datensammeleinrichtung weiterübertragbar sind, wobei
es sich bei der ersten Kommunikationsschnittstelle (7a) um eine drahtlose Nahbereichsschnittstelle zur drahtlosen Anbindung des Zählers handelt, welche eine Mehrzahl von Übertragungsprotokollen (8a-8e) wahlweise unterstützt, und wobei
es sich bei der zweiten Kommunikationsschnittstelle (7b) um eine Fernbereichsschnittstelle handelt, welche eine Mehrzahl von Übertragungsprotokollen (9a-9e) wahlweise unterstützt,
wobei
- eine Antenne (6) zur Kommunikation über die erste (7a) sowie die zweite Kommunikationsschnittstelle (7b) vorgesehen ist oder
- eine erste Antenne (6a) zur Kommunikation über die erste Kommunikationsschnittstelle (7a) und eine zweite Antenne (6b) zur Kommunikation über die zweite Kommunikationsschnittstelle (7b) vorgesehen ist, wobei
das Kommunikationsmodul (1) dazu ausgebildet ist, mit einer Mehrzahl von Zählern (10a, 10b, 10c, 10d) und/oder übergeordneten Datensammeleinrichtungen und/oder Kommunikationsmodulen (1) zu kommunizieren,
**dadurch gekennzeichnet, dass**
das Kommunikationsmodul (1) Mittel zum Festlegen des jeweiligen Übertragungsprotokolls umfasst, um den Übertragungsstandard bzw. das Übertragungsprotokoll zu identifizieren über den das anzuschließende Gerät bzw. der Zähler kommuniziert, wobei dieser Übertragungsstandard zur Anbindung des Zählers selbsttätig gewählt wird, wobei
eine Störerdetektion vorgesehen ist und die Festlegung des Übertragungsprotokolls anhand der Störerdetektion erfolgt.

2. Kommunikationsmodul (1) nach Anspruch 1, **dadurch gekennzeichnet, dass** die erste Kommunikationsschnittstelle (7a) mindestens zwei Übertragungsprotokolle aus folgender Gruppe umfasst:
- Near Field Communication (NFC),
- Infrarot (Infrared Data Association, IrDA),
- Bluetooth,
- Bluetooth Low Energy (BLE),
- Open metering System (OMS) und
- induktive Übertragung.

3. Kommunikationsmodul (1) nach einem der Ansprüche 1 bis 2, **dadurch gekennzeichnet, dass** eine dritte Kommunikationsschnittstelle (7c) vorgesehen ist, über die die Verbrauchsdaten vom Zähler (10a, 10b, 10c, 10d) zum Kommunikationsmodul (1) übertragbar sind.

4. Kommunikationsmodul (1) nach Anspruch 3, **dadurch gekennzeichnet, dass** es sich bei der dritten Kommunikationsschnittstelle (7c) um eine insbesondere nicht-standardisierte Nahbereichs- und/oder insbesondere nicht-standardisierte Fernbereichsschnittstelle handelt, welche mindestens ein oder wahlweise mehrere insbesondere nicht-standardisierte Übertragungsprotokolle unterstützt.

5. Kommunikationsmodul (1) nach einem der vorhergehenden Ansprüche, **dadurch gekennzeichnet, dass** die Antenne (6) bzw. die Antennen (6a, 6b) innerhalb des Kommunikationsmoduls (1) integriert ist bzw. sind.

6. Kommunikationsmodul (1) nach einem der vorhergehenden Ansprüche, **dadurch gekennzeichnet, dass** eine Mehrzahl von Antennen (6, 6a, 6b) vorgesehen ist.

7. Kommunikationsmodul (1) nach einem der vorhergehenden Ansprüche, **dadurch gekennzeichnet, dass** ein Datenspeicher (5) zum Speichern der Verbrauchsdaten vorgesehen ist.

8. Kommunikationsmodul (1) nach einem der vorhergehenden Ansprüche, **dadurch gekennzeichnet, dass** das Kommunikationsmodul (1) dazu ausgebildet ist, Zähler (10a, 10b, 10c, 10d) über eine der Kommunikationsschnittstellen (7a, 7b, 7c) mit Energie zu versorgen.

## Claims

1. Communication module (1) for the acquisition of consumption data of a meter (10a, 10b, 10c, 10d), in particular consumption quantities of electricity, gas, water or heat, wherein the communication module (1) serves to receive consumption data from the meter (10a, 10b, 10c, 10d) and to enable the transmission of the consumption data of the meter (10a, 10b, 10c, 10d) to a superordinate data collection apparatus, with
a housing (2),
a control apparatus (3),
its own energy source (4),
a first communication interface (7a) for wireless connection of the meter, using which the consumption data can be transmitted from the meter (10a, 10b, 10c, 10d) to the communication module (1),
a second communication interface (7b) using which the consumption data can be further transmitted from the communication module (1) to the data collection apparatus, wherein
the first communication interface (7a) is a wireless close-range interface for wireless connection of the meter, which supports a plurality of transmission protocols (8a-8e) as options, and wherein
the second communication interface (7b) is a long-range interface which supports a plurality of transmission protocols (9a-9e) as options,
wherein
- an antenna (6) is provided for communication using the first communication interface (7a) as well as the second communication interface (7b), or
- a first antenna (6a) is provided for communication using the first communication interface (7a) and a second antenna (6b) is provided for communication using the second communication interface (7b), wherein
the communication module (1) is designed to communicate with a plurality of meters (10a, 10b, 10c, 10d) and/or superordinate data collection apparatuses and/or communication modules (1), **characterized in that**
the communication module (1) comprises means for specifying the respective transmission protocol in order to identify the transmission standard or transmission protocol over which the device or meter that is to be connected communicates, wherein this transmission standard is automatically selected to connect the meter, wherein
an interference detection function is provided and the specification of the transmission protocol takes place with reference to the interference detection.

2. Communication module (1) according to Claim 1, **characterized in that** the first communication interface (7a) comprises at least two transmission protocols from the following group:
- Near Field Communication (NFC),
- infrared (Infrared Data Association, IrDA),
- Bluetooth,
- Bluetooth Low Energy (BLE),
- Open Metering System (OMS) and
- inductive transmission.

3. Communication module (1) according to one of Claims 1 to 2, **characterized in that** a third communication interface (7c) is provided using which the consumption data can be transmitted from the meter (10a, 10b, 10c, 10d) to the communication module (1).

4. Communication module (1) according to Claim 3, **characterized in that** the third communication interface (7c) is an in particular non-standardized close-range and/or in particular non-standardized long-range interface that supports at least one or, optionally, a plurality of in particular non-standardized transmission protocols.

5. Communication module (1) according to one of the preceding claims **characterized in that** the antenna (6) or the antennas (6a, 6b) is or are integrated into the communication module (1).

6. Communication module (1) according to one of the preceding claims, **characterized in that** a plurality of antennas (6, 6a, 6b) is provided.

7. Communication module (1) according to one of the preceding claims, **characterized in that** a data memory (5) is provided for storing the consumption data.

8. Communication module (1) according to one of the preceding claims, **characterized in that** the communication module (1) is designed to supply meters (10a, 10b, 10c, 10d) with energy using one of the communication interfaces (7a, 7b, 7c).

## Revendications

1. Module de communication (1) destiné à acquérir des données de consommation d'un compteur (10a, 10b, 10c, 10d), notamment des données de consommation d'électricité, de gaz, d'eau ou de chaleur, le module de communication (1) servant à recevoir les données de consommation de la part du compteur (10a, 10b, 10c, 10d) et à rendre possible la transmission des données de consommation du compteur (10a, 10b, 10c, 10d) à un dispositif de collecte de données de niveau supérieur, comprenant
un boîtier (2),
un dispositif de commande (3),
une source d'énergie (4) propre,
une première interface de communication (7a) servant à la connexion sans fil du compteur et par le biais de laquelle les données de consommation peuvent être transmises du compteur (10a, 10b, 10c, 10d) au module de communication (1),
une deuxième interface de communication (7b), par le biais de laquelle les données de consommation peuvent être retransmises du module de communication (1) au dispositif de collecte de données,
la première interface de communication (7a) étant une interface de champ proche sans fil servant à la connexion sans fil du compteur, laquelle prend en charge au choix une pluralité de protocoles de transmission (8a-8e), et la deuxième interface de communication (7b) étant une interface de champ lointain, laquelle prend en charge au choix une pluralité de protocoles de transmission (9a-9e),
- une antenne (6) servant à la communication par le biais de la première (7a) ainsi que de la deuxième interface de communication (7b) étant présente ou
- une première antenne (6a) servant à la communication par le biais de la première interface de communication (7a) et une deuxième antenne (6b) servant à la communication par le biais de la deuxième interface de communication (7b) étant présentes,
le module de communication (1) étant configuré pour communiquer avec une pluralité de compteurs (10a, 10b, 10c, 10d) et/ou de dispositifs de collecte de données de niveau supérieur et/ou de modules de communication (1),
**caractérisé en ce que**
le module de communication (1) comporte des moyens destinés à spécifier le protocole de transmission respectif, afin d'identifier la norme de transmission ou le protocole de transmission par le biais de laquelle/duquel communique l'appareil ou le compteur à connecter, cette norme de transmission étant choisie automatiquement pour la connexion du compteur,
une détection de perturbation étant présente et la spécification du protocole de transmission s'effectuant à l'aide de la détection de perturbation.

2. Module de communication (1) selon la revendication 1, **caractérisé en ce que** la première interface de communication (7a) comprend au moins deux protocoles de transmission issus du groupe suivant :
- communication en champ proche (NFC),
- infrarouge (Infrared Data Association, IrDA),
- Bluetooth,
- Bluetooth faible consommation (BLE),
- système de comptage ouvert (OMS) et
- transmission inductive.

3. Module de communication (1) selon l'une des revendications 1 à 2, **caractérisé en ce qu'**une troisième interface de communication (7c) est présente, par le biais de laquelle les données de consommation peuvent être transmises du compteur (10a, 10b, 10c, 10d) au module de communication (1).

4. Module de communication (1) selon la revendication 3, **caractérisé en ce que** la troisième interface de communication (7c) est une interface de champ proche notamment non normalisée et/ou de champ lointain notamment non normalisée, laquelle prend en charge au moins un ou sélectivement plusieurs protocoles de transmission notamment non normalisés.

5. Module de communication (1) selon l'une des revendications précédentes, **caractérisé en ce que** l'antenne (6) ou les antennes (6a, 6b) est ou sont intégrée(s) à l'intérieur du module de communication (1).

6. Module de communication (1) selon l'une des revendications précédentes, **caractérisé en ce qu'**une pluralité d'antennes (6, 6a, 6b) sont présentes.

7. Module de communication (1) selon l'une des revendications précédentes, **caractérisé en ce qu'**une mémoire de données (5) est présente pour l'enregistrement des données de consommation.

8. Module de communication (1) selon l'une des revendications précédentes, **caractérisé en ce que** le module de communication (1) est configuré pour alimenter le compteur (10a, 10b, 10c, 10d) en énergie par le biais de l'une des interfaces de communication (7a, 7b, 7c).
